Europäisches Patentamt

European Patent Office

Office européen des brevets

(11) Veröffentlichungsnummer: **0 216 286**
**A2**

## (12) EUROPÄISCHE PATENTANMELDUNG

(21) Anmeldenummer: 86112715.7

(51) Int. Cl.⁴: **H01L 21/00**

(22) Anmeldetag: 15.09.86

(30) Priorität: 25.09.85 DE 8527387 U

(43) Veröffentlichungstag der Anmeldung:
01.04.87 Patentblatt 87/14

(84) Benannte Vertragsstaaten:
**AT BE CH DE FR GB IT LI NL**

(71) Anmelder: **Siemens Aktiengesellschaft Berlin
und München**
**Wittelsbacherplatz 2**
**D-8000 München 2(DE)**

(72) Erfinder: **Fritz, Otmar, Dipl.-Ing.**
**Johann, Hackl-Ring 64**
**D-8011 Neukeferloh(DE)**

(54) **Trägerkörper für integrierte Bausteine.**

(57) Der Trägerkörper besteht aus einem eine zentrale Aussparung 5 umschließenden Rechteckrahmen, der aus Zwei Flanschen (1, 2) und zwei Verbindungsstegen (4) gebildet wird. In den Flanschen (1, 2) und in den Verbindungsstegen (4) sind mehrere parallele Führungsrillen (6) zur Aufnahme von seitlich aus dem integrierten Baustein (9,11) herausgeführten Anschlußdrähten (10,12) vorgesehen, wobei die Verbindungsstege (4) wenigstens doppelt so viele Führungsrillen (6) aufweisen wie die Flansche (1, 2). Die in der zentralen Aussparung (5) vorgesehenen Haltestege (7) mit zugehörigen Haltenasen (8) sind so angeordnet, daß wahlweise Bausteine (11), die mit ihren nur an zwei gegenüberliegenden Seiten herausgeführten Anschlußdrähten (12) alle Führungsrillen (6) der Verbindungsstege (4) belegen und Bausteine (9) mit an allen vier Seiten in gleicher Anzahl herausgeführten Anschlußdrähten (10) einsetzbar sind.

FIG2

EP 0 216 286 A2

## Trägerkörper für integrierte Bausteine

Die Erfindung bezieht sich auf einen Trägerkörper für integrierte Bausteine nach den Merkmalen des Oberbegriffs des Schutzanspruchs.

Bei integrierten Bausteinen besteht die Gefahr, daß sie insbesondere an den Anschlußdrähten sehr leicht beschädigt werden können. Sie werden deshalb unmittelbar nach ihrer Herstellung in einen hinsichtlich der Gehäuseform und der jeweiligen Anordnung der Anschlußdrähte entsprechend angepaßten Trägerkörper eingesetzt. Dieser Trägerkörper dient sowohl als Verpackung, insbesondere beim Transport, als auch zur Handhabung des integrierten Bausteins bei der Prüfung und Montagevorbereitung, zum Beispiel beim Reinigen des Bausteins, beim Aufkleben des Kühlkörpers, bei der Beschriftung der Baustein usw.. Darüber hinaus bildet der Trägerkörper bei entsprechender Werkstoffwahl bzw. Oberflächenbehandlung Schutz gegen elektrostatische Störeinflüsse.

Neben integrierten Bausteinen mit quadratischem Gehäuse, die an allen vier Seiten flach herausgeführte Anschlußdrähte aufweisen, sind auch Bausteine mit rechteckigem Gehäuse bekannt, bei denen die Anschlußdrähte nur an zwei gegenüberliegenden Seiten angeordnet sind. Wegen der unterschiedlichen Gehäuseform weichen auch die zugehörigen Trägerkörper in Form und Größe voneinander ab und selbst für integrierte Bausteine mit gleicher Gehäuseform, jedoch unterschiedlicher Anschlußzahl wer den vielfach unterschiedliche Trägerkörper verwendet. Für die Fertigung bedeutet das für jeden Typ von Trägerkörpern eine eigene Linie bei der Montagevorbereitung.

Der vorliegenden Erfindung liegt deshalb die Aufgabe zugrunde, einen Trägerkörper für integrierte Bausteine so universell auszubilden, daß er sowohl für quadratische als auch für rechteckige Gehäuseformen verwendbar ist, so daß bei der Fertigung und Montagevorbereitung einheitliche Werkzeuge und Einrichtungen benutzt werden können.

Ausgehend von einem Trägerkörper nach dem Oberbegriff des Schutzanspruchs ergibt sich die Lösung dieser Aufgabe erfindungsgemäß durch die kennzeichnenden Merkmale dieses Anspruchs.

Ein Ausführungsbeispiel der Neuerung wird im folgenden anhand der Zeichnung näher erläutert. Dabei zeigen

FIG 1 einen Trägerkörper gemäß der Neuerung für einen integrierten Baustein mit quadratischem Gehäuse,

FIG 2 den Trägerkörper nach FIG 1 mit einem integrierten Baustein, dessen Gehäuse eine rechteckige Form aufweist.

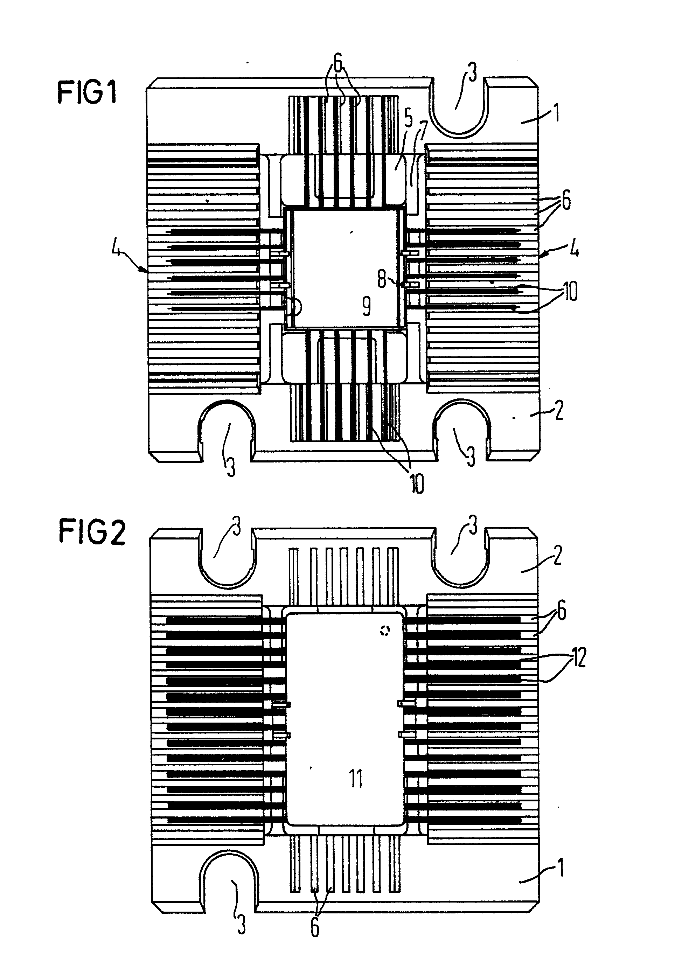

Der in FIG 1 dargestellte Trägerkörper besteht aus zwei Flanschen 1, 2 mit einer bzw. zwei nach außen offenen Nuten 3 zur Aufnahme von Haltestiften sowie aus zwei Verbindungsstegen 4, die zusammen mit den Flanschen 1, 2 einen eine zentrale Aussparung 5 umschließenden Rechteckrahmen bilden. Die beiden Flansche 1, 2 und die beiden Verbindungsstege 4 weisen jeweils mehrere paral lel verlaufende Führungsrinnen 6 auf. In der zentralen Aussparung 5 sind in der FIG 1 nur zum Teil sichtbare Haltestege 7 vorgesehen, die zusammen mit aufgesetzten Haltenasen 8 zur Halterung des integrierten Bausteins 9 dienen. Dieser Baustein 9 hat ein quadratisches Gehäuse mit jeweils sechs Anschlußdrähten 10 an jeder der vier Gehäuseseiten. Da jeder der beiden Verbindungsstege 4 wenigstens doppelt so viele Führungsrillen 6 aufweist, wie jeder der beiden Flansche 1, 2, bleiben bei dem in FIG 1 dargestellten Baustein 9 einige Führungsrillen 6 in den Verbindungsstegen 4 ungenutzt.

Wie die FIG 2 zeigt, werden die Führungsrillen 6 in den beiden Verbindungsstegen 4 des Trägerkörpers dann voll genutzt, wenn ein integrierter Baustein 11 mit rechteckigem Gehäuse verwendet wird, bei dem die Anschlußdrähte 12 ausschließlich an den beiden Längsseiten des Gehäuses herausgeführt sind. Dafür bleiben hier die Führungsrillen in den beiden Flanschen 1 und 2 ungenutzt. Wie die Anordnungen nach FIG 1 und 2 zeigen, kann somit der universell ausgebildete Trägerkörper für integrierte Bausteine mit unterschiedlichen Gehäuseformen und unterschiedlicher Anzahl und Anordnung der Anschlußdrähte verwendet werden.

## Ansprüche

Trägerkörper für integrierte Bausteine, bei dem zwei parallele Flansche, die jeweils wenigstens eine nach außen offene Nut zur Aufnahme je eines Haltestiftes aufweisen, zusammen mit zwei Verbindungsstegen einen eine zentrale Aussparung umschließenden Rechteckrahmen bilden, bei dem in den Flanschen und in den Verbindungsstegen mehrere jeweils parallel verlaufende Führungsrillen zur Aufnahme von seitlich aus dem integrierten Baustein herausgeführten Anschlußdrähten vorgesehen sind und bei dem in der Aussparung mehrere ein-oder beidseitig mit den Flanschen verbundene Haltestege mit aufgesetzten Haltenasen für den integrierten Baustein angeordnet sind, **dadurch gekennzeichnet,** daß die Verbindungsstege (4) wenigstens doppelt so viele Führungsrillen (6) aufweisen, wie die Flansche (1, 2) und daß die Haltestege (7) und die Haltenasen - (8) in der zentralen Aussparung (5) so angeordnet sind, daß wahlweise Bausteine (11) die mit ihren nur an zwei gegenüberliegenden Seiten herausgeführten Anschlußdrähten (12) alle Führungsrillen (6) der Verbindungsstege (4) belegen und Bausteine (9) mit an allen vier Seiten in gleicher Anzahl herausgeführten Anschlußdrähten (10) einsetzbar sind.

FIG1

FIG2